# FASCICULE DE BREVET EUROPEEN

(11) **EP 0 298 882 B1**
(45) Date de publication et mention de la délivrance du brevet: **10.03.1993**
(21) Numéro de dépôt: 88420229.2
(22) Date de dépôt: 29.06.1988
(51) Int. Cl.: H01L 29/10, H01L 29/743, H01L 29/747

(54) **Thyristor de protection à gachette auxiliaire**
Schutzthyristor mit Hilfssteuerelektrode
Protection thyristor with an auxiliary gate electrode

(30) Priorité: 03.07.1987 FR 8709457
(43) Date de publication de la demande: 11.01.1989
(73) Titulaire: SGS-THOMSON MICROELECTRONICS S.A., 94250 Gentilly (FR)
(72) Inventeur: Jeudi, Patrice, F-37000 La Membrolle (FR); Anceau, Christine, F-37700 saint Pierre des Corps (FR)
(74) Mandataire: de Beaumont, Michel

(56) Documents cités:
- EP-A- 0 194 936
- US-A- 3 697 827
- PATENT ABSTRACTS OF JAPAN, vol. 6, no. 238 (E-144)[1116], 26 novembre 1982; & JP-A-57 138 175

## Description

L'invention concerne les thyristors et triacs de protection.

Par thyristor ou triac de protection on entend un composant à deux électrodes principales que l'on peut placer entre deux bornes d'une installation à protéger, par exemple entre les bornes d'un poste téléphonique, entre les bornes d'alimentation en énergie d'un circuit, etc. Le thyristor de protection est normalement non conducteur et devient conducteur lorsqu'il reçoit entre ses bornes une tension de polarité inverse dépassant un seuil bien déterminé que l'on appelle tension de retournement. Pour les tensions de polarité directe, le thyristor est bloqué (voir par example EP-A-0 194 936).

Le triac de protection est non conducteur pour les deux polarités et devient conducteur au-delà d'un seuil (tension de retournement) pour la polarité directe comme pour la polarité inverse.

Dans la description qui suit on ne parlera que de thyristors de protection, l'invention étant également applicable à un triac constitué par deux thyristors tête-bêche.

Les thyristors de protection se distinguent des thyristors de commutation habituels non seulement par leur structure interne dans laquelle les profils de diffusion des différentes régions sont choisis pour remplir le rôle de déclenchement automatique de conduction qu'on leur assigne (déclenchement pour une tension aussi précise que possible), mais aussi par le fait qu'ils n'ont pas d'électrode de gâchette.

Selon l'invention, on s'est aperçu que dans certaines applications il pouvait être utile que le thyristor de protection, chargé de court-circuiter deux bornes d'un circuit à protéger, puisse être déclenché par mesure de protection non seulement quand une surtension se présente sur ses bornes, mais aussi dans d'autres cas nécessitant une protection, par exemple dans le cas d'une détection d'échauffement anormal du circuit à protéger.

C'est pourquoi la présente Invention propose d'incorpore à un thyristor ou un triac de protection une gâchette dans une structure réalisée de manière à conserver, sans altérer ses performances, la fonction principale du composant, c'est-à-dire sa fonction de protection.

La structure de thyristor selon l'invention comprend une région d'anode de type P, une région centrale de type N, une région de gâchette de type P, une région d'émetteur de type N, la région centrale étant surdopée au-dessous d'une métallisation d'émetteur recouvrant partiellement la région d'émetteur, la région de gâchette comportant une partie de faible épaisseur là où elle est adjacente à la région surdopée, et une partie plus épalsse là où elle est adjacente au reste de la région centrale, la région d'émetteur s'étendant en surface au-dessus de la région surdopée et débordant au-delà de cette région, une électrode de gâchette étant formée en surface de la région de gâchette dans sa région la plus épaisse, entre l'électrode de gâchette et la région surdopée, la région de gâchette présente une partie de largeur rétrécie par rapport à la largeur de cette région au dessus de la partie surdopée.

Par cette structure, on constate qu'on peut obtenir une excellente séparation des deux fonctions de déclenchement du thyristor, c'est-à-dire de la fonction de déclenchement par dépassement d'un seuil de tension (fonction de protection) et la fonction de déclenchement par application d'un courant de gâchette (fonction de déclenchement commandé). La séparation des fonctions qui est ainsi obtenue évite d'avoir à adopter un compromis entre un bon thyristor de protection et un bon thyristor commandé par gâchette compromis qui aboutirait fatalement à un thyristor médiocre aussi bien dans sa fonction de protection que dans sa fonction de composant commandé.

En particuller, la structure selon l'invention permet, si on le désire, de réaliser un thyristor ayant un fort courant de maintien tout en ayant un faible courant de déclenchement par la gâchette. Le courant de maintien est le seuil de courant Ih tel que si le courant traversant le thyristor descend au-dessous de Ih, alors le thyristor se bloque naturellement. Un courant de maintien élevé est souhaitable en général pour un composant de protection : de cette manière, lorsque le composant s'est déclenché en présence d'une surtension, il revient facilement à son état bloqué dès que le courant qui le traverse diminue, c'est-à-dire dès que disparaît la surcharge qui a causé le déclenchement.

Pour un thyristor commandé par un courant de gâchette, il est souvent intéressant d'avoir un faible courant de déclenchement Ig (courant de gâchette minimum nécessaire pour rendre le thyristor conducteur).

Mais il faut savoir que dans les thyristors classiques le courant de maintien et le courant de déclenchement par la gâchette sont fortement liés, c'est-à-dire que si on veut augmenter le courant de maintien, alors le courant de déclenchement par la gâchette augmentera aussi. Grâce à la structure selon l'invention, on peut obtenir à la fois un fort courant de maintien et un faible courant de déclenchement, et ceci sans perturber la fonction de déclenchement par surtension entre les électrodes principales.

D'autres caractéristiques et avantages de l'invention apparaîtont à la lecture de la description détaillée qui suit et qui est faite en référence aux dessins annexés dans lesquels :
- la figure 1 représente une coupe transversale de thyristor selon l'invention,
- la figure 2 représente une vue de dessus correspondante, pour une structure en peigne.

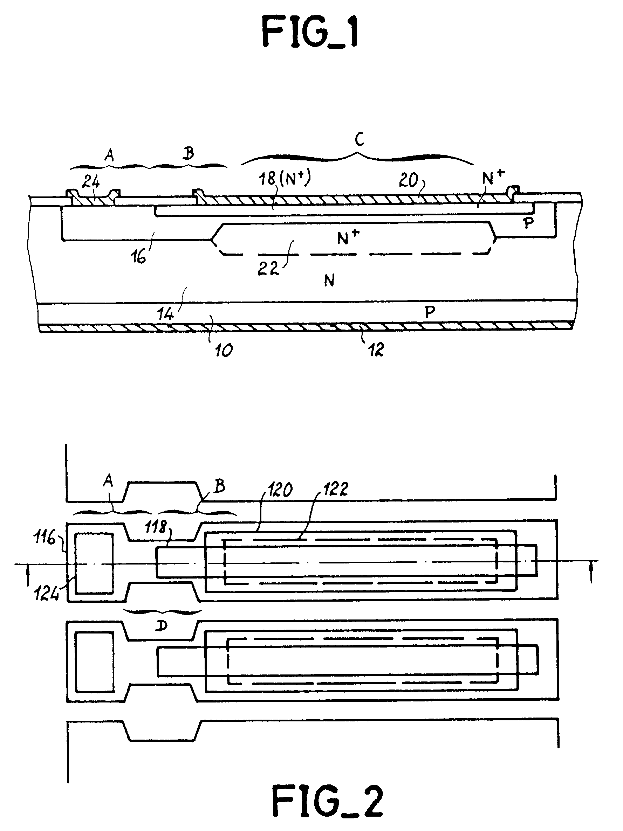

La coupe de la figure 1 fait clairement apparaître les différentes couches de types de conductivité alternés du thyristor selon l'invention (l'invention s'applique aussi à un triac constitué de deux thyristors tête-bêche juxtaposés sur une même puce de circuit-intégré).

Les couches sont les suivantes: une couche d'anode 10 de type P affleurant sur la face arrière et recouverte par une métallisation d'anode 12; une couche centrale 14 de type N; une couche de gâchette 16 de type P; une couche d'émetteur 18 de type N.

La couche d'émetteur 18 est recouverte par une métallisation d'émetteur 20.

La couche centrale 14 comporte une partie surdopée 22 adjacente à la couche de gâchette 16; cette partie surdopée s'enfonce à l'intérieur de la couche de gâchette, de sorte que la jonction entre la couche de gâchette et la couche centrale présente un décrochement au lieu d'être plane sur sensiblement toute sa surface.

La couche de gâchette est ainsi divisée en une première partie où elle est adjacente à une région moins dopée de la couche centrale et une deuxième partie où elle est adjacente à une région plus dopée 22 de la couche centrale.

La première partie de la couche de gâchette comprend une zone A où elle remonte à la surface de la tranche semiconductrice, et une zone B où elle passe au dessous de la région d'émetteur; en effet la région d'émetteur est diffusée superficiellement dans une partie de la couche de gâchette; dans la zone A, une métallisation de gâchette 24 recouvre la partie affleurante de la couche de gâchette pour créer un contact d'accès à cette couche.

La deuxième partie de la couche de gâchette comprend essentiellement une zone C dans laquelle l'épaisseur de la couche de gâchette est réduite (par rapport à l'épaisseur dans la zone B) par suite de la présence de la région surdopée 22 qui remonte dans la couche de gâchette.

Comme on le voit sur la figure 1, la région d'émetteur s'étend au dessus de toute la région surdopée 22, mais aussi au delà puisqu'elle recouvre aussi la zone B.

Sur la figure 2, qui représente une vue de dessus du thyristor, on a représenté les contours des différentes régions diffusées qui viennent d'être mentionnées, ainsi que les contours des métallisations de la face avant.

La structure donnée à titre d'exemple est une structure en peigne, c'est à dire que la région de gâchette est subdivisée en multiples régions individuelles en forme de doigts parallèles reliés électriquement par une électrode de gâchette commune; de même, la région d'émetteur est subdivisée en multiples régions en forme de doigts, chaque doigt d'émetteur étant diffusé à l'intérieur d'un doigt respectif de gâchette et les doigts d'émetteur étant tous reliés entre eux par l'intermédiaire d'une électrode d'émetteur commune.

Les contours des différentes régions sont repérés sur un seul doigt de la structure en peigne.

La référence 116 désigne le contour, vu de dessus, de la région diffusée de type P 16 constituant la couche de gâchette.

La référence 118 désigne le contour de la région d'émetteur 18 de type N diffusée superficiellement dans une partie de la couche de gâchette.

La référence 120 désigne le contour du contact d'émetteur 20.

La référence 122 désigne le contour, en traits tiretés de la région surdopée 22 de type N⁺.

La référence 124 désigne désigne le contour du contact de gâchette 24.

Sur la figure 2, on voit clairement que, conformément à l'invention, la région de gâchette 16 présente une partie de largeur rétrécie par rapport à la largeur que présente cette même région au dessus de la zone surdopée 22. Cette partie de largeur réduite est désignée par D sur la figure 2. Elle est située dans l'une ou l'autre des zones A et B ou dans les deux à la fois. Dans l'exemple de la figure 2, elle s'étend en partie dans la zone A et en partie dans la zone B.

On notera que le contact d'émetteur 20 déborde au delà de la région d'émetteur 18 et est directement en contact avec la région de gâchette sur de petites zones latérales; ce contact sert à l'évacuation des charges stockées dans le thyristor lors de sa conduction, pour faciliter le retour du thyristor à l'état bloqué.

A titre d'exemple, la partie surdopée 22 de la couche centrale 14 du thyristor est environ 10 fois plus dopée que le rete de la couche centrale. La largeur de la région de gâchette dans sa portion rétrécie peut être moitié de la largeur de cette région au dessus de la partie surdopée 22.

La structure peut être réalisée par des procédés classiques de diffusion et d'implantation: par exemple, on part d'un substrat semiconducteur de type N que l'on oxyde superficiellement; on ouvre localement l'oxyde par photogravure selon un motif correspondant au contour 122; on implante des impuretés de type N; cette implantation est suivie ultérieurement d'une rediffusion des impuretés, cette rediffusion aboutissant à la formation de la région 22; dans l'oxyde recréé par cette rediffusion, on ouvre une fenêtre correspondant au contour 116, en même temps que la face arrière de la tranche est complètement désoxydée; on dépose et diffuse une impureté de type P, constituant ainsi les régions de gâchette et d'anode; on ouvre une nouvelle fenêtre de diffusion selon un motif corrrespondant au contour 118 et on diffuse une impureté de type N, aboutissant à la formation de la région d'émetteur 18 à l'intérieur de la région de gâchette et avec un prolongement (zone B) au delà de la région surdopée 22; des ouvertures de contact sont faites à l'emplacement du contact de gâchette et du contact d'émetteur (contours 124 et 120) en même temps que la face arrière de la tranche est complètement désoxydée, et la métallisation est effectuée de manière classique.

## Revendications

1. Thyristor de protection fonctionnant par mise en conduction lors du dépassement d'un seuil de tension prédéterminé entre son anode et sa cathode, comprenant une région d'anode (10) de type P, une région centrale (14) de type N, une région de gâchette (16) de type P, une région d'émetteur de type N, une électrode d'anode (12) en contact avec la région d'anode, et une électrode d'émetteur (20) en contact avec la région d'émetteur, caractérisé en ce que
- la région centrale (14) comporte une partie surdopée (22) au dessous de l'électrode d'émetteur;
- le thyristor de protection comporte une électrode de gâchette (24) en contact avec la région de gâchette;
- la région de gâchette comporte une partie de faible épaisseur (C) là où elle est adjacente à la partie surdopée de la région centrale et une partie plus épaisse (A,B) là où elle est adjacente au reste de la région centrale, l'électrode de gâchette étant en contact avec la région de gâchette dans sa partie plus épaisse;
- entre l'électrode de gâchette et la région surdopée, la région de gâchette présente une partie de largeur rétrécie (D) par rapport à la largeur de cette région au dessus de la partie surdopée;
- la région d'émetteur s'étend en surface au dessus de la partie surdopée et déborde au delà de cette partie surdopée du côté de l'électrode de gâchette.

## Claims

1. A protection thyristor turning on whenever a predetermined voltage threshold between its anode and cathode is exceeded, comprising a P-type anode region (10), a N-type central region (14), a P-type gate region (16), a N-type emitter region, an anode electrode (12) in contact with the anode region, and an emitter electrode (20) in contact with the cathode region, characterized in this that the central region (14) comprises an overdoped region (22) below the emitter electrode ;
- the protection thyristor comprises a gate electrode (24) in contact with the gate region ;
- the gate region comprises a portion of little thickness (C) at the location where it is adjacent to the overdoped portion of the central region and a thicker portion (A, B) at the location where it is adjacent to the remaining portion of the central region, the gate electrode being in contact with the gate region, the gate electrode being in contact with the gate region in its thicker part ;
- between the gate electrode and the overdoped region, the gate region presents a portion of narrowed width (D) with respect to the width of the region above the overdoped region ;
- the emitter region extends above said overdoped region and protrudes above said overdoped portion towards the gate electrode.

## Patentansprüche

1. Schutzthyristor, der während des Überschreitens einer vorbestimmten Spannungsschwelle zwischen seiner Anode und seiner Kathode durch Übergang in den leitenden Zustand anspricht und der einen Anodenbereich (10) des P-Typs, einen Zentralbereich (14) des N-Typs, einen Gate-Bereich (16) des P-Typs, einen Emitterbereich des N-Typs, eine Anodenelektrode (12) in Kontakt mit dem Anodenbereich und eine Emitterelektrode (20) in Kontakt mit dem Emitterbereich umfaßt, dadurch gekennzeichnet, daß
- der Zentralbereich (14) einen überdotierten Abschnitt (22) unterhalb der Emitterelektrode enthält,
- der Schutzthyristor eine Gate-Elektrode (24) in Kontakt mit dem Gate-Bereich enthält,
- der Gate-Bereich einen Abschnitt mit geringer Dicke (C) dort, wo er an den überdotierten Abschnitt des Zentralbereichs angrenzt, und einen dickeren Abschnitt (A, B) dort, wo er an den Rest des Zentralbereichs angrenzt, enthält, wobei die Gate-Elektrode mit dem Gate-Bereich in dessen dickerem Abschnitt in Kontakt steht,
- der Gate-Bereich zwischen der Gate-Elektrode und dem überdotierten Bereich einen Abschnitt mit veringerter Breite (D) verglichen mit der Breite dieses Bereichs oberhalb des überdotierten Abschnitts aufweist,
- der Emitterbereich sich an der Oberfläche oberhalb des überdotierten Abschnitts erstreckt und über diesen überdotierten Abschnitt auf der Seite der Gate-Elektrode hinausgeht.
